# EUROPÄISCHE PATENTSCHRIFT

(11) **EP 3 341 931 B1**
(45) Veröffentlichungstag und Bekanntmachung des Hinweises auf die Patenterteilung: **13.03.2024**
(21) Anmeldenummer: 16732296.5
(22) Anmeldetag: 27.06.2016
(51) Int. Cl.: G10K 9/22, G10K 13/00

(54) **AKUSTISCHER SENSOR MIT EINEM GEHÄUSE UND EINEM AN DIESEM GEHÄUSE ANGEORDNETEN MEMBRANELEMENT**
ACOUSTIC SENSOR WITH A HOUSING AND A MEMBRANE ELEMENT ARRANGED ON SAID HOUSING
CAPTEUR ACOUSTIQUE POURVU D'UN BOÎTIER ET D'UN ÉLÉMENT DIAPHRAGME DISPOSÉ SUR CE BOÎTIER

(30) Priorität: 25.08.2015 DE 102015216200
(43) Veröffentlichungstag der Anmeldung: 04.07.2018
(73) Patentinhaber: Robert Bosch GmbH, 70442 Stuttgart (DE)
(72) Erfinder: KARL, Matthias, 76275 Ettlingen (DE)
(86) Internationale Anmeldenummer: PCT/EP2016/064820
(87) Internationale Veröffentlichungsnummer: WO 2017/032482

(56) Entgegenhaltungen:
- DE-A1- 19 744 229
- DE-A1-102012 200 639
- DE-U1-202007 007 135
- US-A- 3 943 388
- US-A- 4 459 037
- US-A- 5 636 182

## Beschreibung

### Stand der Technik

Die vorliegende Erfindung betrifft einen akustischen Sensor.

Bei einer typischen Gestaltung eines akustischen Sensors, insbesondere dann, wenn der akustische Sensor ein Ultraschallsensor ist, wird typischerweise eine Piezokeramik auf einen Boden eines topfförmigen Gehäuses geklebt. Der Topfboden ist dabei derart ausgeführt, dass dieser als eine Membran wirkt.

Ein solcher Aufbau eines akustischen Sensors liegt zumeist darin begründet, dass der elektroakustische Wandler und eine eventuell zugehörige Elektronik vor Umwelteinflüssen geschützt werden sollen. Dies wird bei einem solchen Ultraschallsensor dadurch gewährleistet, dass die Membran ein Teilbereich des Gehäuses ist und die Piezokeramik im Inneren des Gehäuses angeordnet ist.

Bei dem geschilderten Aufbau eines Ultraschallsensors besteht jedoch wenig Spielraum bezüglich einer Gestaltung des Gehäuses und der Membran, da die Membran beispielsweise über das Innere des Gehäuses zugänglich sein muss, damit die Piezokeramik an dieser angeordnet werden kann. Dies steht insbesondere einer Ausgestaltung von besonders flachen akustischen Sensoren entgegen.

Die US 5,636,182 A offenbart einen akustischen Sensor bei dem zwischen einem Wandlertopf und einem Trägerelement ein Dichtungsring angeordnet ist. Die DE 197 44 229 A1 und die DE 20 2007 007 135 U1 offenbaren weitere akustische Sensoren mit jeweils einem Wandlertopf. Die Dokumente US 3 943 388 A und DE 10 2012 200639 A1 zeigen weitere akustische Sensoren. Die Schrift US 4 459 037 A offenbart des Weiteren eine Armbanduhr mit einem piezoelektrischen Aktor, welche ein Uhrengehäuse und einen Gehäuseboden umfasst.

### Offenbarung der Erfindung

Der erfindungsgemäße akustische Sensor umfasst ein Trägerelement, ein Membranelement, welches auf einer ersten Seite des Trägerelements angeordnet ist, und einen elektroakustischen Wandler, der auf einer dem Trägerelement zugewandten Seite des Membranelementes angeordnet ist, und dazu eingerichtet ist, zumindest einen Bereich des Membranelements zu einer Schwingung anzuregen, wobei das Membranelement an zumindest einem Randbereich einen Halterungsbereich aufweist, der sich in Richtung des Trägerelements erstreckt und einen Teilbereich des Trägerelements umgreift.

Da der Halterungsbereich des Membranelementes einen Teilbereich des Trägerelementes umgreift, wird dieser Teilbereich von dem Halterungsbereich umlaufen. Das bedeutet mit anderen Worten, dass Abschnitte des Halterungsbereiches des Membranelementes auf unterschiedlichen Seiten des Teilbereiches des Trägerelementes angeordnet sind. Insbesondere liegt dabei ein Formschluss zwischen dem Halterungsbereich des Membranelements und dem Trägerelement vor. Da sich der Halterungsbereich in Richtung des Trägerelements erstreckt liegt dabei eine Verdickung der Membran vor.

Auf diese Weise wird ein akustischer Sensor geschaffen, der einen hohen Freiheitsgrad bei der Gestaltung des Trägerelementes ermöglicht und zugleich den elektroakustischen Wandler zuverlässig vor Umwelteinflüssen schützt. Zudem wird eine Kombination aus einem Verschluss und der Membran gebildet, wodurch eine Anzahl notwendiger Komponenten zur Realisierung des akustischen Wandlers verringert wird.

Die Unteransprüche zeigen bevorzugte Weiterbildungen der Erfindung.

Es ist vorteilhaft, wenn der Halterungsbereich des Membranelementes federelastisch ist und mit dem Teilbereich des Trägerelements eine Schnappverbindung bildet. Auf diese Weise wird eine besonders einfache Montage des Membranelements auf dem Trägerelement ermöglicht. Diese kann gegebenenfalls auch gelöst werden.

Auch ist es vorteilhaft, wenn der Teilbereich des Trägerelements zumindest Abschnitte eines Gewindeganges bildet und der Halterungsbereich des Membranelementes einen Abschnitt aufweist, der so geformt ist, dass dieser in den Gewindegang eingreift. Somit kann das Membranelement auf das Trägerelement aufgeschraubt werden. Gerade durch eine solche Schraubverbindung kann ein hoher Grad an Dichtigkeit und somit eine hohe Schutzwirkung gegenüber Umwelteinflüssen geschaffen werden.

Ferner ist es vorteilhaft, wenn der Halterungsbereich des Membranelementes aus einem thermisch schrumpfbaren Material gebildet ist, und das Membranelement durch ein erwärmen des Membranelement mit dem Trägerelement verbunden wurde. Insbesondere wurde das Membranelement dabei durch ein Erwärmen des Halterungsbereichs mit dem Trägerelement verbunden. Mit anderen Worten ist das Membranelement auf das Trägerelement aufgeschrumpft. Eine solche Verbindung zwischen dem Membranelement und dem Trägerelement weist eine hohe Dichtigkeit auf. Zudem ist eine Fertigung eines solchen akustischen Sensors besonders einfach zu bewerkstelligen, da bei einem solchen akustischen Sensor eine hohe Fehlertoleranz bezüglich Fertigungsabweichung an dem Membranelement und an dem Trägerelement vorliegt.

Es ist vorteilhaft, wenn das Membranelement zumindest teilweise elastisch ist und in seiner Dimension so gewählt ist, dass bei einem Umgreifen des Halterungsbereichs durch das Membranelement ein Anpressdruck zwischen dem Halterungsbereich und dem Trägerelement besteht. Damit wird ebenfalls eine hohe Dichtigkeit des akustischen Sensors an einem Übergang zwischen dem Membranelement und dem Trägerelement gewährleistet.

Erfindungsgemäß weißt das Trägerelement eine Kavität auf, welche auf einer Seite des Trägerelementes angeordnet ist, die durch das Membranelement überspannt wird. Die Kavität bildet insbesondere einen Reflexionsbereich, durch welchen akustische Signale, welche von dem Membranelement ausgehen, reflektiert werden und in eine primäre Senderichtung des akustischen Sensors zurückgeworfen werden. Dies ermöglicht es, eine Richtcharakteristik des akustischen Sensors zu gestalten. Ferner wird dadurch ein Freiraum für ein Schwingen des Membranelementes geschaffen.

Auch ist es vorteilhaft, wenn das Trägerelement eine Leiterplatte ist. Somit können weitere elektronische Komponenten des akustischen Sensors direkt auf dem Trägerelement angeordnet werden. Eine besonders einfache und flache Konstruktion des akustischen Sensors wird geschaffen.

Erfindungsgemäß ist vorgesehen, dass das Trägerelement auf einer dem Membranelement abgewandten Seite des Trägerelements eine Aufnahme aufweist, in der eine Elektronik zur Anregung des elektroakustischen Wandlers angeordnet ist. Das Trägerelement dient somit als ein Gehäuse. Dadurch, dass die Elektronik auf einer dem Membranelement abgewandten Seite des Trägerelements angeordnet ist, wird vermieden, dass eine Oberflächenstruktur der Elektronik Einfluss auf eine Schallausbreitung in dem akustischen Sensor nimmt.

Zudem ist es vorteilhaft, wenn ein Dichtelement zwischen der dem Trägerelement zugewandten Seite des Membranelements und dem Trägerelement angeordnet ist. Insbesondere ist das Dichtelement durch ein 2K-Spritzgußverfahren einstückig mit dem Membranelement oder dem Trägerelement geformt. Es wird somit ein besonders dichter akustischer Sensor geschaffen.

Ebenso vorteilhaft ist es, wenn das Trägerelement in dem Halterungsbereich eine Kavität aufweist, in welcher das Dichtelement angeordnet ist. Dabei weist das Dichtelement bevorzugt eine Lippe auf, welche einen Übergang zwischen Trägerelement und Membranelement abdichtet. Somit wird ein besonders dichter Übergang zwischen Trägerelement und Membranelement gewährleistet.

### Kurze Beschreibung der Zeichnungen

Nachfolgend werden Ausführungsbeispiele der Erfindung unter Bezugnahme auf die begleitende Zeichnung im Detail beschrieben. In der Zeichnung ist:
- Figur 1: eine schematische Darstellung eines akustischen Sensors in einer ersten Ausführungsform der Erfindung,
- Figur 2: eine schematische Darstellung eines akustischen Sensors in einer zweiten Ausführungsform der Erfindung,
- Figur 3a: ein Abschnitt eines akustischen Sensors gemäß einer dritten Ausführungsform der Erfindung,
- Figur 3b: ein Abschnitt eines akustischen Sensors gemäß einer vierten Ausführungsform der Erfindung, und
- Figur 3c: ein Abschnitt eines akustischen Sensors gemäß einer fünften Ausführungsform der Erfindung.

### Ausführungsformen der Erfindung

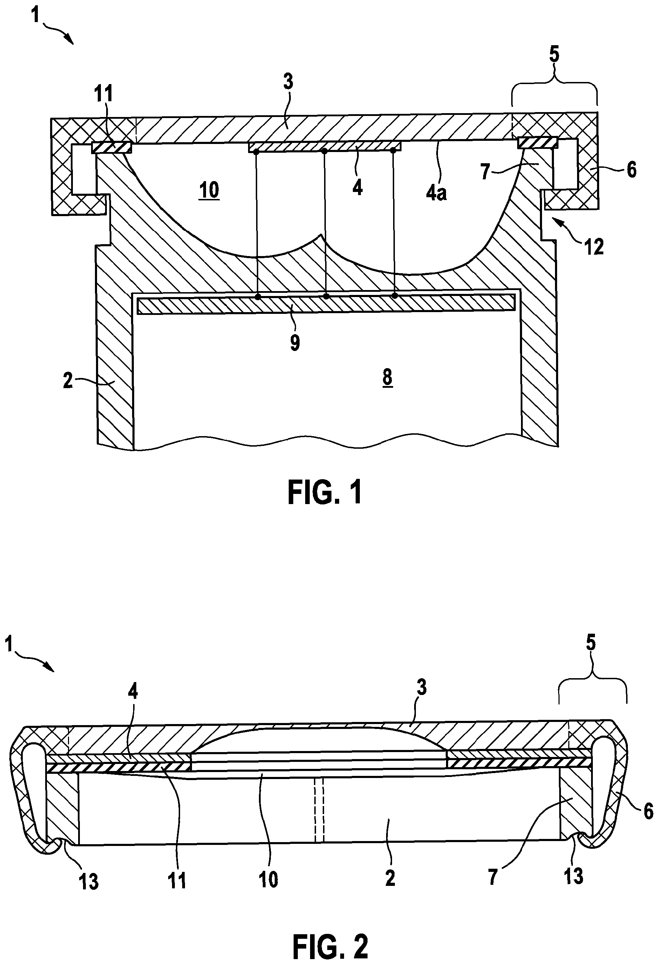

Figur 1 zeigt eine schematische Darstellung eines akustischen Sensors 1 gemäß einer ersten Ausführungsform der Erfindung. Es ist ein Querschnitt durch den akustischen Sensor 1 gezeigt. Der akustische Sensor 1 umfasst ein Trägerelement 2, ein Membranelement 3 und einen elektroakustischen Wandler 4.

Das Trägerelement 2 weist erfindungsgemäß als Grundform die Form eines Vollzylinders auf. Dieser Vollzylinder weist auf einer ersten Seite und auf einer zweiten Seite, welche der ersten Seite des Trägerelements 2 gegenüberliegt, jeweils eine kreisscheibenförmigen Oberfläche auf. Eine Oberfläche des Vollzylinders und somit des Trägerelementes 2, welches die erste Seite und die zweite Seite verbindet, wird als eine Umfangsfläche bezeichnet.

Auf der ersten Seite des Trägerelementes 2, also einer der kreisscheibenförmigen Oberflächen des Vollzylinders, ist eine Kavität 10 eingebracht. Die Kavität 10 erstreckt sich dabei derart auf der ersten Seite des Trägerelements 2, dass ein Steg bestehen bleibt, der einen Randbereich der auf der ersten Seite des Trägerelements 2 gelegenen Fläche bildet. Wie in Figur 1 ersichtlich ist, kann die Kavität 10 eine unterschiedliche Tiefe über ihren Verlauf entlang der ersten Seite des Trägerelementes 2 aufweisen. So ist die Kavität 10 in der in Figur 1 gezeigten ersten Ausführungsform eine ringförmige Senke, welche ein Zentrum der ersten Seite des Trägerelementes 2 umläuft. Die Tiefe ändert sich erfindungsgemäß sowohl über einen Radius der ersten Seite hinweg, als auch entlang einer Umlaufrichtung der ersten Seite, also azimuthal. So weist die Kavität 10 in dieser ersten Ausführungsform auf einer in dem in Figur 1 gezeigten Querschnitt links gelegenen Seite des Trägerelements 2 eine unterschiedliche Tiefe gegenüber einer rechts gelegenen Seite auf. Somit legen Schallwellen, die in diesen unterschiedlichen Bereichen der Kavität 10 reflektiert werden, unterschiedliche Distanzen zurück. Damit wird eine Richtcharakteristik des akustischen Sensors 1 beeinflusst.

Auf der zweiten Seite des Trägerelements 2, welche der ersten Seite des Trägerelements 2 gegenüberliegt, ist eine Aufnahme 8 in das Trägerelement 2 eingebracht. Die Aufnahme 8 ist beispielsweise ein Sackloch, welches in die zweite Seite des Trägerelements 2 eingebracht ist und sich entlang einer Zylinderachse des Trägerelements 2 erstreckt. Dieser Abschnitt des Trägerelements 2 kann somit als ein Hohlzylinder betrachtet werden. Zwischen der auf der ersten Seite des Trägerelements 2 eingebrachten Kavität 10 und der Aufnahme 8 besteht ein Bereich des Trägerelements, der die Kavität 10 und die Aufnahme 8 voneinander trennt.

Die Umfangsfläche des Trägerelements 2 weist eine Verjüngung 12 auf. Die Verjüngung 12 ist ein Bereich, in dem ein Radius des Vollzylinders, welcher die Grundform des Trägerelements 2 bildet, verringert ist. Die Verjüngung 12 ist derart in einem Bereich der Umfangsfläche angeordnet, dass ein Abstand größer Null zu der ersten Seite besteht.

Auf der ersten Seite des Trägerelements 2 ist ein Membranelement 3 angeordnet. Das Membranelement 3 ist ein flexibles Element, welches an zumindest einem Randbereich 5 einen Halterungsbereich 6 aufweist, der sich in Richtung des Trägerelements 2 erstreckt und einen Teilbereich 7 des Trägerelements 2 umgreift. Das Membranelement 3 kann dabei gänzlich oder teilweise flexibel sein.

Das Membranelement 3 überspannt die erste Seite des Trägerelements 2 und ist in diesem Bereich, in dem es die erste Seite überspannt, flächig geformt. In dem Randbereich 5 des Membranelements 3 weist das Membranelement 3 den Halterungsbereich 6 auf. Der Halterungsbereich 6 wird in dieser ersten Ausführungsform dadurch gebildet, dass das Membranelement 3 sich an seinem äußeren Umfang parallel zu der Zylinderachse des Trägerelements 2 entlang dem Trägerelement 2 erstreckt und sich nach einer Distanz, welche sich zumindest bis zu der Verjüngung 12 erstreckt, wiederum parallel zu der das Trägerelement 2 überspannten Oberfläche in Richtung eines Zentrums des Trägerelements 2, also nach Innen, erstreckt. Dabei erstreckt sich der Halterungsbereich 6 des Membranelementes 3 zumindest so weit in Richtung des Zentrums des Trägerelements 2, dass dieses sich in die Verjüngung 12 hinein erstreckt. Der Halterungsbereich 6 bildet in seinem Querschnitt somit eine U-Form, die auch in Figur 1 in dem Randbereich 5 des Membranelements 3 erkenntlich ist.

Das Trägerelement 2 weist somit einen Teilbereich 7 auf, der von dem Membranelement 3 umgriffen wird. Zu diesem Teilbereich 7 gehört insbesondere der Bereich des Trägerelements 2, der zwischen der Verjüngung 12 und der ersten Seite des Trägerelements 2 liegt. Somit weist das Trägerelement 2 einen Bereich auf, in dem auf zwei gegenüberliegenden Seiten jeweils ein Abschnitt des Membranelementes 3 angeordnet ist.

Auf einer dem Trägerelement 2 zugewandten Seite 4a des Membranelementes 3 ist der elektroakustische Wandler 4 angeordnet. Der elektroakustische Wandler 4 ist ein kreisscheibenförmiges Element und ist in einem Zentrum der Oberfläche des Membranelements 3 angeordnet, welche die erste Seite des Trägerelements 2 überspannt.

Der elektroakustische Wandler 4 ist dazu eingerichtet, zumindest einen Bereich des Membranelements 3 zu einer Schwingung anzuregen. Der elektroakustische Wandler 4 ist in dieser ersten Ausführungsform mit dem Membranelement 3 verschweißt. In alternativen Ausführungsformen kann das Membranelement 3 jedoch auch an dem Trägerelement 2 fixiert sein und lediglich in losem Kontakt zu dem Membranelement 3 stehen. Der elektroakustische Wandler 4 ist in dieser ersten Ausführungsform ein Piezoelement. Dieses kann durch ein Anlegen eines elektrischen Signals zu einer mechanischen Bewegung angeregt werden.

In der Aufnahme 8 des Trägerelements 2 ist eine Elektronik 9 angeordnet, welche dieses elektrische Signal auf Anforderung bereitstellt und somit zur Anregung des elektroakustischen Wandlers 4 geeignet ist. Die Elektronik 9 ist somit innerhalb des Trägerelements 2 angeordnet, wodurch dieses als ein Gehäuse betrachtet werden kann. Die Elektronik 9 ist über mehrere elektrische Zuleitungen mit dem elektroakustischen Wandler 4 verbunden.

Wie zuvor beschrieben überspannt das Membranelement 3 das Trägerelement 2 auf der ersten Seite. Dabei liegt das Membranelement 3 in dieser ersten Ausführungsform nicht unmittelbar auf dem Trägerelement 2 auf, sondern liegt auf einem Dichtelement 11 auf, welches zwischen der dem Trägerelement 2 zugewandten Seite 4a des Membranelements und dem Trägerelement 2 angeordnet ist. Das Dichtelement 11 ist in dieser ersten Ausführungsform ein Ring, welcher aus einem elastischen Material geformt ist, und auf der ersten Seite des Trägerelements 2 aufliegt. Dabei ist ein Innenumfang und ein Außenumfang des Dichtelement 11 derart gewählt, dass es in einem Bereich des Trägerelements 2 aufliegt, der außerhalb der Kavität 10 liegt. Das Dichtelement 11 liegt somit auf dem Steg auf der zwischen der Kavität 10 und der Umfangsfläche des Trägerelements besteht. Somit wird eine Dichtheit des akustischen Sensors 1 in einem Übergangsbereich zwischen Trägerelement 2 und Membranelement 3 verbessert. In alternativen Ausführungsformen wird auf das Dichtelement verzichtet.

Bevorzugt ist ein Innenmaß des Membranelements 3 kleiner als ein Außenmaß des Trägerelements 2. Dabei ist es vorteilhaft, wenn das Membranelement 3 zumindest teilweise elastisch ist. Somit ist das Membranelement 3 in seiner Dimension derart gewählt, dass bei einem Umgreifen des Halterungsbereiches 6 durch das Membranelement 3 ein Anpressdruck zwischen dem Halterungsbereich 6 und dem Trägerelement 2 besteht.

Figur 2 zeigt eine schematische Darstellung eines akustischen Sensors 1 gemäß einer zweiten Ausführungsform der Erfindung. Es ist ein Querschnitt durch den akustischen Sensor 1 gezeigt.

In dieser zweiten Ausführungsform ist das Trägerelement 2 eine kreisscheibenförmige Leiterplatte. Die kreisscheibenförmige Leiterplatte 2 weist auf ihrer dem Membranelement 2 zugewandten kreisscheibenförmigen Oberfläche eine Kavität 10 auf. Dazu ist die kreisrunde Oberfläche des Trägerelements 2, welche auf der ersten Seite liegt, nach innen eingewölbt, so dass sich eine Senke ergibt. Eine Tiefe der Senke ist dabei so gewählt, dass ein freies Schwingen des Membranelementes 2 bei einer Anregung durch den elektroakustischen Wandler 4 möglich ist.

Das Trägerelement 2 weist auf einer zweiten Seite, welche eine der ersten Seite gegenüberliegende Seite ist, eine Nut 13 auf, welche die kreisrunde Oberfläche des Trägerelements auf der zweiten Seite an deren äußeren Umfang umläuft.

Das Membranelement 3 weist an seinem äußeren Umfang, also in seinem Randbereich 5, mehrere Klammerelemente auf. Diese Klammerelemente bilden den Halterungsbereich 6. Die Anteile des Membranelements 3, welche den Halterungsbereich 6 bilden, sind federelastisch. Wird das Membranelement 3 bei einer Montage des akustischen Sensors 1 auf das Trägerelement 2 gepresst, so weitet sich der Halterungsbereich 5 des Membranelementes 3, da dieser federelastisch ist, und das Trägerelement 2 kann in die Klammern des Membranelementes 3 eingeführt werden. Es besteht somit eine Schnappverbindung zwischen dem Membranelement 3 und einem Teilbereich 7 des Trägerelements 2. Der Teilbereich 7 des Trägerelements 2 ist dabei ein äußerer Umfang des Trägerelements 2. Die Nut 13 verläuft in dem Teilbereich 7 auf der zweiten Seite des Trägerelements 2. Die Klammerelemente sind derart geformt, dass diese einen Bereich aufweisen, der in die Nut 13 eingreift, wenn das Membranelement 3 mit dem Trägerelement 2 verbunden ist.

Da das Trägerelement 2 in dieser zweiten Ausführungsform eine Leiterplatte ist, ist die Elektronik 9 zur Anregung des akustischen Wandlers 4 direkt auf dem Trägerelement 2, beispielsweise auf der zweiten Seite des Trägerelementes 2 angeordnet. Dabei ist der elektroakustische Wandler 4 über Leiterbahnen kontaktiert, die von der zweiten Seite des Trägerelementes 2 auf die erste Seite des Trägerelementes 2 geführt sind.

Der elektroakustische Wandler 4 weist in dieser zweiten Ausführungsform einen ringförmigen Aufbau auf. Dieser weist einen äußeren Umfang auf, der einem äußeren Umfang der kreisrunden Oberfläche des Trägerelements 2 entspricht. Zwischen dem elektroakustischen Wandler 4 und dem Trägerelement 2 ist das Dichtelement 11 angeordnet, welches in dieser zweiten Ausführungsform ebenfalls ringförmig ausgeführt ist und dessen ringförmige Oberfläche der ringförmigen Oberfläche des elektroakustischen Wandlers 4 entspricht. Der elektroakustische Wandler 4 liegt auf dem Membranelement 3 auf. Das Dichtelement 11 befindet sich zwischen dem elektroakustischen Wandler 4 und dem Trägerelement 2.

Somit ist der elektroakustische Wandler 4 zwischen das Membranelement 3 und das Trägerelement 2 geklemmt. Der elektroakustische Wandler 4 muss somit nicht gesondert an dem Membranelement 3 oder dem Trägerelement 2 befestigt werden. Ein Anpressdruck an das Membranelement 3 wird durch das flexible Dichtelement 11 weiter erhöht.

Wie aus Figur 2 ersichtlich ist, weist das Membranelement 3 in dem Bereich, der das Trägerelement 2 überspannt, eine Dünnstelle auf, welche innerhalb des Ringes liegt, der durch den elektroakustischen Wandler 4 beschrieben wird. Dadurch wird ein Schwingungswiderstand des Membranelements 3 minimiert.

In dieser zweiten Ausführungsform ist die Höhe des Trägerelementes 2 so gering, dass die nach innen gerichtete Abschnitte des Membranelementes 3 das Trägerelement 2 hintergreifen kann. Das Membranelement 3 hat einen beispielhaften Durchmesser von 16 mm. Die Ränder des Membranelementes 3 hintergreifen das Trägerelement 2 und greifen in mechanische Vertiefungen ein, sodass ein Verschieben der Ränder nur mit einer deutlich stärkeren Kraft möglich ist, weil dazu die Membranränder aus der Vertiefung geschoben werden müssten. Die Leiterplatte hat eine beispielhafte Dicke von 2 mm.

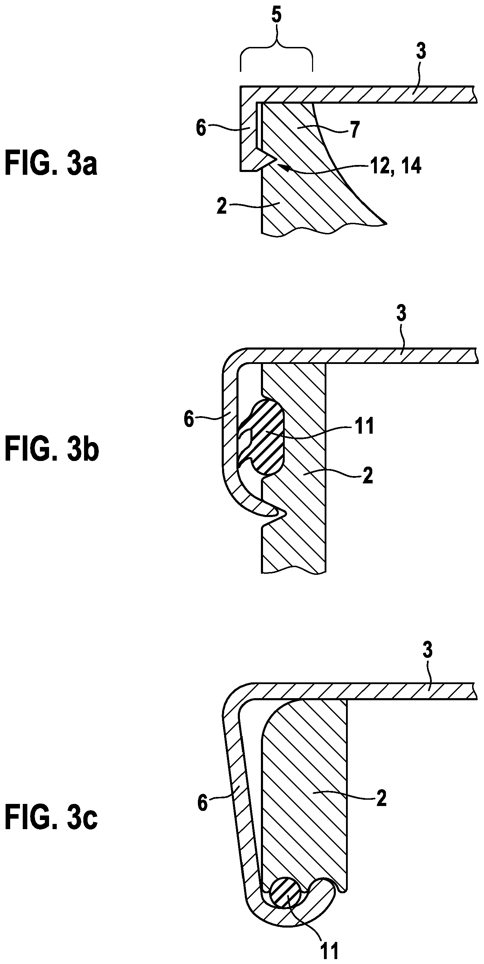

Figur 3 zeigt eine schematische Darstellung eines Querschnitts durch einen Abschnitt eines akustischen Sensors 1 in einer dritten Ausführungsform. Die dritte Ausführungsform entspricht im Wesentlichen der zuvor beschriebenen ersten oder zweiten Ausführungsform. Auch in dieser dritten Ausführungsform wird durch das Membranelement 3 und das Trägerelement 2 eine Schnappverbindung gebildet. Dabei ist der Anteil des Membranelements 3, welcher in das Trägerelement 2 einrastet, besonders spitz ausgeführt. Die Verjüngung 12 weist dabei eine gegenüber der Umfangsfläche schräg stehende Seite auf. Dadurch wird das Membranelement 3 auf das Trägerelement 2 gedrückt, wenn der Halterungsbereich aufgrund seiner Elastizität einen Druck auf diese Seite des Verjüngung 12 ausübt.

Mit Bezug auf Figur 3a wird ebenfalls eine alternative Ausführungsform der Erfindung beschrieben, in welcher der Teilbereich 7 des Trägerelementes, welcher von dem Halterungsbereich 6 umgriffen wird, einen Gewindegang 14 bildet. Ein Querschnitt durch einen beispielhaften akustischen Sensor 1, in welcher der Teilbereich 7 des Trägerelements 2 einen Gewindegang 14 bildet, entspricht ebenfalls dem in Figur 3a gezeigten Querschnitt. Dabei variiert jedoch in Abhängigkeit von einer gewählten Schnittachse für den Querschnitt ein Abstand zwischen der Senke und der auf der ersten Seite des Trägerelements 2 gelegenen Oberfläche des Trägerelements 2. Somit kann das Membranelement 3 auf das Trägerelement 2 aufgeschraubt werden. Dabei ist es nicht zwingend notwendig, dass der Halterungsbereich 6 federelastisch ist. Das Membranelement 3 ist somit als ein Deckel auf das Trägerelement 2 aufgeschraubt, ähnlich einem Deckel, der auf ein Marmeladenglas geschraubt ist. Dazu ist der Halterungsbereich 6 des Membranelements 3 derart geformt, dass dieses einen Abschnitt aufweist, der so geformt ist, dass dieser in den Gewindegang 14 eingreift. Der Gewindegang 14 kann in seinem Verlauf auch Unterbrechungen aufweisen.

Figur 3b zeigt eine schematische Darstellung eines Querschnitts durch einen Abschnitt des akustischen Sensors 1 in einer vierten Ausführungsform. Die vierte Ausführungsform entspricht im Wesentlichen den zuvor beschriebenen Ausführungsformen. Wie auch in der ersten und zweiten Ausführungsform ist in dieser vierten Ausführungsform das Dichtelement 11 zwischen dem Trägerelement 2 und dem Membranelement 3 angeordnet. Dazu weist das Trägerelement 2 eine Kavität auf, in welcher das Dichtelement 11 angeordnet ist. Das Dichtelement 11 ist dabei entweder ein eigenständiges Element oder ist integral mit dem Membranelement 3 oder dem Trägerelement 2 geformt. Die Kavität, in welcher das Dichtelement 11 angeordnet ist, ist in dieser vierten Ausführungsform eine Senke, welche einen äußeren Umfang des Trägerelementes 2 umläuft.

Der Rand des Membranelements 3 greift seitlich, also auf Seiten der Umfangsfläche des Trägerelements 2, mit seinem nach innen gerichteten Abschnitt in einen nach außen gerichteten Abschnitt des Trägerelements 2 ein, wobei in dem von dem Halterungsbereich umgriffenen Teilbereich des Trägerelementes 2 das Dichtelement 11 eingeklemmt ist. In dieser Ausführungsform ist das Dichtelement 11 mit Dichtlippen ausgestattet, die bevorzugt derart schräg orientiert sind, dass diese wie ein Widerhaken ein Zusammenfügen des Membranelements 2 und des Trägerelements 2 kaum behindern. Bei einem Versuch das Membranelement 3 und Trägerelement 2 zu Trennen stellen diese sich jedoch einer Bewegung entgegen.

Bevorzugt weist der Rand des Trägerelementes 2 an der Stelle, an welcher der Rand des Membranelements 3 beim Zusammenfügen von Membranelement 3 und Trägerelement 2 erstmals mit dem Gehäuserand in Kontakt kommt, eine Einfügehilfe auf, um das Überwinden der Presspassung zu erleichtern.

Figur 3c ist eine schematische Darstellung eines Querschnitts durch einen akustischen Sensor 1 gemäß einer fünften Ausführungsform der Erfindung. Diese fünfte Ausführungsform der Erfindung zeigt eine alternative Anordnung des Dichtelementes 11. Dabei ist das Dichtelement 11 in einer Kavität angeordnet, welche ebenfalls einen äußeren Umfang des Trägerelementes 2 umläuft, jedoch auf einer der ersten Seite abgewandten Seite des Trägerelements 2 angeordnet ist.

In weiteren alternativen Ausführungsformen wurde das Membranelement 3 aus einem thermisch schrumpfbaren Material geformt und wird auf das Trägerelement 2 durch thermisches Erhitzen aufgeschrumpft.

Nebst obenstehender Offenbarung wird explizit auf die Offenbarung der Figuren 1 bis 3c verwiesen.

## Patentansprüche

1. Akustischer Sensor (1), umfassend:
- ein Trägerelement (2), wobei das Trägerelement (2) als Grundform die Form eines Vollzylinders aufweist,
- ein Membranelement (3), welches auf einer ersten Seite des Trägerelements (2) angeordnet ist, und
- einen elektroakustischen Wandler (4), der auf einer dem Trägerelement (2) zugewandten Seite (4a) des Membranelementes (3) angeordnet ist, und dazu eingerichtet ist, zumindest einen Bereich des Membranelements (3) zu einer Schwingung anzuregen,
wobei
- das Membranelement (3) an zumindest einem Randbereich (5) einen Halterungsbereich (6) aufweist, der sich in Richtung des Trägerelements (2) erstreckt und einen Teilbereich (7) des Trägerelements (2) umgreift, und
- das Trägerelement (2) auf einer dem Membranelement (3) abgewandten Seite eine Aufnahme (8) aufweist, in der eine Elektronik (9) zur Anregung des elektroakustischen Wandlers (4) angeordnet ist,
**dadurch gekennzeichnet, dass**
- das Trägerelement (2) eine Kavität (10) aufweist, welche auf der Seite des Trägerelementes (2) angeordnet ist, die durch das Membranelement (3) überspannt wird, wobei
- sich die Tiefe der Kavität (10) sowohl über einen Radius der ersten Seite hinweg, als auch entlang einer Umlaufrichtung der ersten Seite ändert, also azimuthal.

2. Akustischer Sensor gemäß Anspruch 1, **dadurch gekennzeichnet, dass** der Halterungsbereich (5) des Membranelementes (3) federelastisch ist und mit dem Teilbereich (7) des Trägerelements (2) eine Schnappverbindung bildet.

3. Akustischer Sensor gemäß Anspruch 1, **dadurch gekennzeichnet, dass** der Teilbereich (7) des Trägerelements zumindest Abschnitte eines Gewindeganges (14) bildet und der Halterungsbereich (6) des Membranelementes (3) einen Abschnitt aufweist, der so geformt ist, dass dieser in den Gewindegang (14) eingreift.

4. Akustischer Sensor gemäß Anspruch 1, **dadurch gekennzeichnet, dass** der Halterungsbereich (6) des Membranelementes (3) aus einem thermisch schrumpfbaren Material gebildet ist, und das Membranelement (3) durch ein Erwärmen des Membranelements (3) mit dem Tragerelement (2) verbunden wurde.

5. Akustischer Sensor gemäß einem der vorhergehenden Ansprüche, **dadurch gekennzeichnet, dass** das Membranelement (3) zumindest teilweise elastisch ist und in seiner Dimension so gewählt ist, dass bei einem Umgreifen des Teilbereichs (7) durch das Membranelement (3) ein Anpressdruck zwischen dem Halterungsbereich (6) und dem Trägerelement (2) besteht.

6. Akustischer Sensor gemäß einem der vorhergehenden Ansprüche, **dadurch gekennzeichnet, dass** das Trägerelement (2) eine Leiterplatte ist.

7. Akustischer Sensor gemäß einem der vorhergehenden Ansprüche, **dadurch gekennzeichnet, dass** ein Dichtelement (11) zwischen der dem Trägerelement (2) zugewandten Seite (4a) des Membranelementes und dem Trägerelement (2) angeordnet ist.

8. Akustischer Sensor gemäß Anspruch 7, **dadurch gekennzeichnet, dass** das Trägerelement (2) in dem Teilbereich (7) eine Kavität aufweist, in welcher das Dichtelement (11) angeordnet ist.

## Claims

1. Acoustic sensor (1), comprising:
- a carrier element (2), wherein the carrier element (2) has, as the basic shape, the shape of a solid cylinder,
- a diaphragm element (3), which is arranged on a first side of the carrier element (2), and
- an electroacoustic transducer (4), which is arranged on a side (4a) of the diaphragm element (3), the said side facing the carrier element (2), and is designed to excite at least one region of the diaphragm element (3) to vibrate,
wherein
- the diaphragm element (3) has, on at least one peripheral region (5), a retaining region (6), which extends in the direction of the carrier element (2) and engages around a subregion (7) of the carrier element (2), and
- the carrier element (2) has, on a side facing the diaphragm element (3), a receptacle (8) in which an electronics system (9) is arranged for exciting the electroacoustic transducer (4),
**characterized in that**
- the carrier element (2) has a cavity (10), which is arranged on the side of the carrier element (2) that is spanned by the diaphragm element (3), wherein
- the depth of the cavity (10) changes both over a radius of the first side and along a circulating direction of the first side, that is to say azimuthally.

2. Acoustic sensor according to Claim 1, **characterized in that** the retaining region (5) of the diaphragm element (3) is spring-elastic and forms a snap-action connection with the subregion (7) of the carrier element (2).

3. Acoustic sensor according to Claim 1, **characterized in that** the subregion (7) of the carrier element forms at least sections of a thread turn (14) and the retaining region (6) of the diaphragm element (3) has a section that is shaped such that it engages in the thread turn (14) .

4. Acoustic sensor according to Claim 1, **characterized in that** the retaining region (6) of the diaphragm element (3) is formed from a thermally shrinkable material, and the diaphragm element (3) was connected to the carrier element (2) by heating the diaphragm element (3).

5. Acoustic sensor according to any of the preceding claims, **characterized in that** the diaphragm element (3) is at least partially elastic and the dimensions of the diaphragm element are selected such that, when the diaphragm element (3) engages around the subregion (7), there is a contact-pressure between the retaining region (6) and the carrier element (2).

6. Acoustic sensor according to any of the preceding claims, **characterized in that** the carrier element (2) is a printed circuit board.

7. Acoustic sensor according to any of the preceding claims, **characterized in that** a sealing element (11) is arranged between the side (4a) of the diaphragm element, the said side facing the carrier element (2), and the carrier element (2).

8. Acoustic sensor according to Claim 7, **characterized in that** the carrier element (2) has a cavity in the subregion (7), the sealing element (11) being arranged in the said cavity.

## Revendications

1. Capteur acoustique (1), comprenant :
- un élément de support (2), l'élément de support présentant comme forme de base la forme d'un cylindre plein,
- un élément formant membrane (3) qui est disposé sur une première face de l'élément de support (2), et
- un transducteur électroacoustique (4) qui est disposé sur une face (4a) de l'élément formant membrane (3) tournée vers l'élément de support (3) et est conçu pour faire vibrer au moins une partie de l'élément formant membrane (3),
dans lequel
- l'élément formant membrane (3) présente dans au moins une zone marginale (5) une zone de fixation (6) qui s'étend en direction de l'élément de support (2) et entoure une zone partielle (7) de l'élément de support (2), et
- l'élément de support (2) présente sur une face détournée de l'élément formant membrane (3) un logement (8) dans lequel est disposée une électronique (9) pour exciter le transducteur électroacoustique (4),
**caractérisé en ce que**
- l'élément de support (2) présente une cavité (10) qui est disposée sur la face de l'élément de support (2) qui est recouverte par l'élément formant membrane (3), dans lequel
- la profondeur de la cavité (10) varie aussi bien sur un rayon de la première face que le long d'une direction circonférentielle de la première face, donc de manière azimutale.

2. Capteur acoustique selon la revendication 1, **caractérisé en ce que** la zone de fixation (5) de l'élément formant membrane (3) fait ressort et constitue avec la zone partielle (7) de l'élément de support (2) un assemblage à encliquetage.

3. Capteur acoustique selon la revendication 1, **caractérisé en ce que** la zone partielle (7) de l'élément de support constitue au moins certaines parties d'un pas de vis (14), et la zone de fixation (6) de l'élément formant membrane (3) présente une partie qui est formée de façon à venir en prise avec le pas de vis (14).

4. Capteur acoustique selon la revendication 1, **caractérisé en ce que** la zone de fixation (6) de l'élément formant membrane (3) est formée en un matériau thermorétractable, et l'élément formant membrane (3) a été relié à l'élément de support (2) par un échauffement de l'élément formant membrane (3).

5. Capteur acoustique selon l'une quelconque des revendications précédentes, **caractérisé en ce que** l'élément formant membrane (3) est au moins partiellement élastique et **en ce que** sa dimension est sélectionnée de telle sorte que lorsque la zone partielle (7) soit entourée par l'élément formant membrane (3), il existe une pression de contact entre la zone de fixation (6) et l'élément de support (2).

6. Capteur acoustique selon l'une quelconque des revendications précédentes, **caractérisé en ce que** l'élément de support (2) est une carte de circuit imprimé.

7. Capteur acoustique selon l'une quelconque des revendications précédentes, **caractérisé en ce qu'**un élément d'étanchéité (11) est disposé entre la face (4a) de l'élément formant membrane, tournée vers l'élément de support (2), et l'élément de support (2).

8. Capteur acoustique selon la revendication 7, **caractérisé en ce que** l'élément de support (2) présente dans la zone partielle (7) une cavité dans laquelle est disposé l'élément d'étanchéité (11).
